(19) Europäisches Patentamt
European Patent Office
Office européen des brevets

(11) EP 0 753 940 B1

(12) **EUROPEAN PATENT SPECIFICATION**

(45) Date of publication and mention
of the grant of the patent:
**25.05.2005 Bulletin 2005/21**

(51) Int Cl.⁷: **H03K 19/00**

(21) Application number: **95830305.9**

(22) Date of filing: **14.07.1995**

(54) **Method and device for softdriving an array of logic gates**

Verfahren und Einrichtung zum sanften Treiben einer Anordnung logischer Gatter

Procédé et dispositif pour tamponner doucement un réseau de portes logiques

(84) Designated Contracting States:
**DE FR GB IT**

(43) Date of publication of application:
**15.01.1997 Bulletin 1997/03**

(73) Proprietor: **STMicroelectronics S.r.l.**
**20041 Agrate Brianza (Milano) (IT)**

(72) Inventors:
• **Onetti, Andrea Mario**
**I-27100 Pavia (IT)**

• **Procurato, Sylvia**
**I-48100 Ravenna (IT)**

(74) Representative: **Pellegri, Alberto et al**
**c/o Società Italiana Brevetti S.p.A.**
**Piazza Repubblica, 5**
**21100 Varese (IT)**

(56) References cited:
**US-A- 4 611 135**     **US-A- 4 633 101**
**US-A- 4 683 386**     **US-A- 5 027 019**
**US-A- 5 121 014**

**Description**

The present invention relates to logic circuits and more in particular driving circuits of logic gate arrays.

In digital systems employing logic gate arrays on a plurality of signal lines of a certain path, for example passgate arrays, it is often found the case of signal lines that are multiplexed in a mutually exclusive manner.

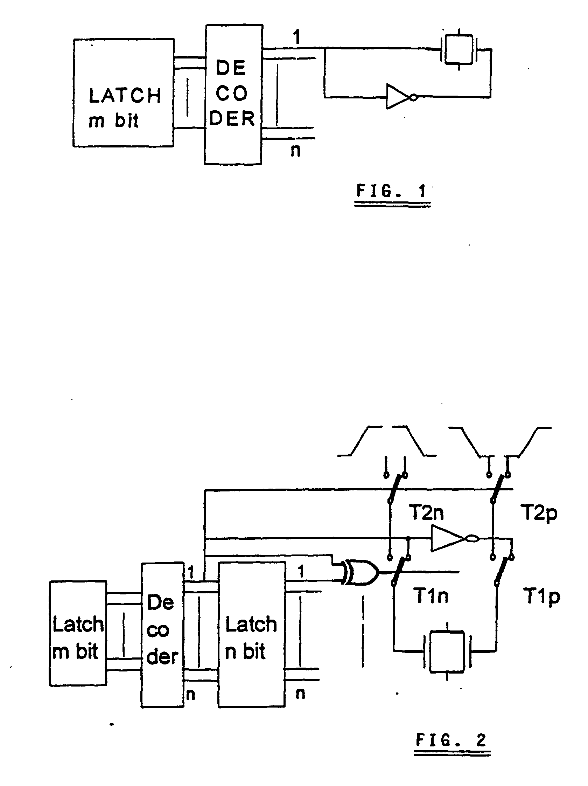

Figure 1 shows a typical example representing an array of n switches, each of which can be implemented by a passgate constituted by a pair of complementary transistors: (n_mos and p_mos) driven in phase opposition, and wherein the n switches are driven by the outputs of a circuit that decodes an m bit digital command.

A single passgate is eventually turned-off by applying a logic high signal to the gate of the n_mos transistor and a logic low signal to the gate of the p_mos transistor, while all the other passgates are maintained in an OFF condition. Following a switching of the decoder, consequent to the acquisition of a different m bit digital command code, takes place the passgate that was previously closed and the simultaneous closing of a different passgate of the other n-1 passgates.

As it will be evident to a technician, the applications of a digital circuit of this type are multiple. For example, in the field of audio processors, for switching among different signal sources, a multiplexer may be used for enabling the selected input leaving all the other disabled. Remaining in the field of audio applications, it is typical the case of digitally controlled attenuators in which a certain analog signal path is selected by closing a certain switch of a plurality of n switches, which switch selects a certain resistance ratio on an n modules voltage divider (multi-tap potentiometer).

A successive switching, that may be commanded by a new digital code, will open the switch that was previously closed and close a different switch that will select a different resistance ratio of the voltage divider and therefore a new value of attenuation. Even in this case, all the other (n-2) switches remain open, being unaffected by the change of attenuation command.

In audio applications, although not exclusively in these, the problems associated with the "DC step" that occurs upon a fast switching of the switches may cause disturbances that in audio systems may be audible in baseband as a click-like noise.

This problem can be minimized by implementing a slow driving (that is a "soft-switching") of the passgates subject to switch from a logic state to another. "Soft-switchings", obtainable by driving the respective node with purposely generated positive or negative voltage ramps, having a duration in the order of several milliseconds, are indeed able to smooth the DC step thus shifting the disturbance spectrum off the used band, for example off the audio band. In view of the fact that only two logic gates (or switches or passgates) among the plurality of them composing the array, are directly affected by the switching, it is necessary to discriminate the respective paths among all the n signal paths. All the other paths must remain unalterate, for example by keeping the respective switches open.

A logic circuit for realizing such a "soft-switching" operation is rather complex and costly in terms of the number of components needed for its realization.

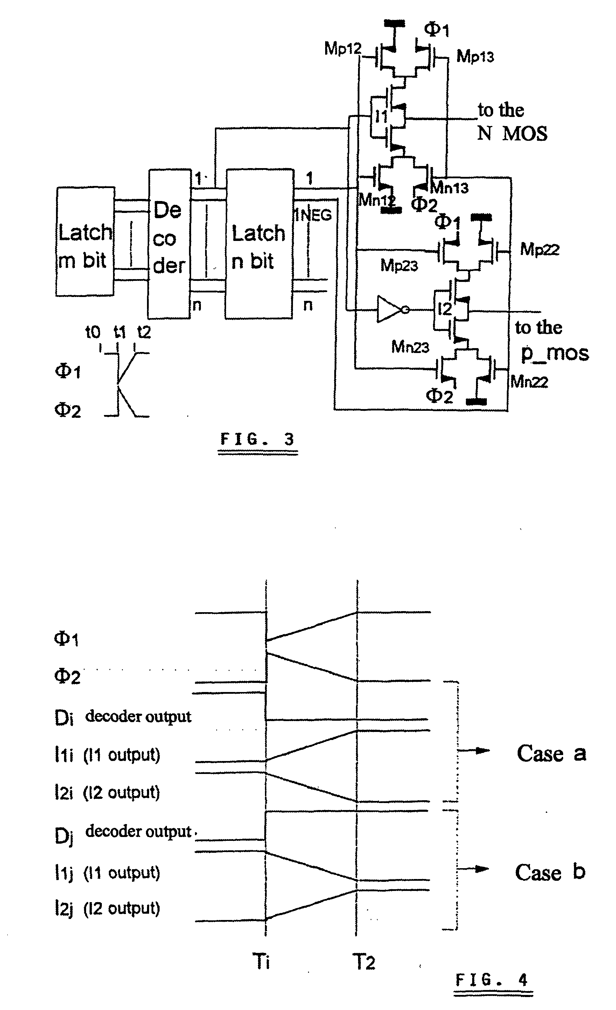

Let aside the controlled generators of the required positive and negative voltage ramps, selectable for causing the "soft-switching" of a certain logic gate or switch or passgate, a circuit Implementing the above described solution schematically depicted in of Fig. 1, is shown in Fig. 2.

In first place, it is necessary to identify, among the n signal paths which are for instance singularly identifiable by a respective passgate, the two paths that are affected by the commanded transition. For this purpose, it is necessary to use an additional transition detecting circuit, coupled in cascade of the decoder, which can be commonly realized using a latch circuit, followed by a logic gate of the exclusive-OR type (XOR) on each output signal path or line of the decoder. The functioning of the circuit is as follows:

    a) for any one line of the n signal lines that is not affected by the transition, the output of the respective XOR closes the T1 switch, in series with the control gate of the passgate directly on the respective output of the decoder;

    b) for any one line affected by the transition, the output of the respective XOR gate switches the T1 switch in series with the control gate of the passgate, on a node onto which a slow ramp signal generated by a dedicated controlled ramp generator develops.

Depending on the type of gate to be driven (for example the control gate of the n_mos transistor or that of the p_mos transistor of a passgate) and depending on the type of the transition of the respective output of the decoder (for example the opening or closing of a passgate) a positive or negative voltage ramp is selected by the use of a second switch T2. The n-bit latch block, in cascade to the decoder, stores the value that preexisted before the contingent (new) switching for the whole duration of the switching ramp, being ultimately updated by the closing of the switch T1 on the respective decoder output.

According to this solution, as referred to in the above described sample application, the circuit block that has to be interposed in cascade connection, between the n-bit latch circuit and the n-output decoder needed for driving in a slowed down manner the passgates affected by the switching, requires a number of components that may be calculated with the following expression:

$$n_{latch}+n(n_{xor}+n_{switch}+n_{inverter})=30*n+4$$

where:

  n = number of decoder outputs

  $n_{xor}$ = number of components of the XOR=4

  $n_{latch}$ = number of components of the n-bit latch=n*8+4

  $n_{switch}$ = number of components of the switches T1p, T2p, T1n, T2n=16

  $n_{inverter}$ = number of components of the inverter=2.

The patent US 5,027,019, upon which the preamble of claim 1 is based, discloses an analog switch circuit which can reduce switching noise while enabling an integrated analog switch circuit configuration.

*Object and summary of the invention*

It has now been found and is the object of the present invention a way of performing a "soft-switching" of a selected logic gate of an array of logic gates subject to a transition, that requires a number of components markedly reduced if compared to the known ways of performing such a "soft-switching".

Fundamentally, the device of this invention for "soft-switching" a logic gate subject to a transition from a logic state to another logic state, as being selectable among a plurality of identical logic gates respectively associated to as many signal lines and which are not simultaneously affected by a transition from a logic state to another logic state, besides comprising latches for storing of the preexistent logic state on each signal line and suitable controlled generators of a positive ramp and negative ramp respectively, whose duration may be preestablished, for each signal line, employs at least an inverter driven by the signal insistent on the respective line for driving the respective logic gate. The driving inverter has at least one or preferably both its current terminals that may be switched by a passgate between the respective common supply potential node and a node on which said positive or negative voltage ramp toward said respective common supply potential is produced. Each switching passgate of the respective current terminal of the inverter is driven by the logic signal of the respective signal line that preexisted the intervening change of configuration and by its inverse.

If in a specific application, it is required to slow down only one of the two switching fronts, for example either the opening or the closing of a passgate, the relative driving inverters of the n_mos and p_mos transistors that form the passgate will have only one current terminal switched by means of a passgate to one or to the other common potential node or to the ramp generator output. Conversely, when wanting to slow down both the closing and opening processes, each driving inverter of the n_mos and p_mos devices of the passgate will have both of their current terminals switched to the respective common potential node or to the ramp generator output by means of a passgate.

The various aspects and relative advantages of this invention will become even more evident through the following description of several important embodiments, and by referring to the attached drawings, wherein:

  **Figure 1**, as already described above, depicts a functional scheme of a passgate array on a certain signal path;

  **Figure 2**, as already described above, shows a known arrangement for implementing a "soft-switching" of the passgates of the array of Fig. 1;

  **Figure 3** shows an embodiment of the present invention for implementing a "soft-switching" of the passgates of an array of passgates;

  **Figure 4** is a diagram of the signals for two different situations of operation of the circuit of the invention of Fig. 3;

  **Figure 5** is a partial scheme of a passgate driving circuit according to this invention for the case wherein only one type of transition is to be slowed-down by applying a ramp drive signal;

  **Figure 6** is a diagram of the signals of the circuit of Fig. 5.

In introducing the specific technical problem and in describing the system of the invention that consistently reduces the number of components required, the circuits shown in the figures refer to the most common case of driving an array of passgates, each of which may be composed of a pair of complementary transistors, for example an n_mos and a p_mos transistor, driven in phase opposition by a logic signal and its inverse. Is it intuitive that the same considerations and the same effects of the circuit arrangement of the present invention remain valid also in the case of driving an array of generic logic gates (not necessarily of the passgate type) or in general terms a plurality (array) of circuital nodes in a mutually exclusive mode at a certain point of a digital code (signal) path.

By referring to the diagram of Fig. 3, the n-bit latch block, placed in cascade to the decoder, stores the configuration (code) PRIOR TO a new change of configuration (switching) and is then updated to the new configuration (code) at the end of the switching process governed by slow ramp drive signals φ1 and φ2 generated by suitable generators (not shown in the figure), as in prior art arrangements as the one described in Fig. 2.

Differently from the known solution of Fig. 2, the driving architecture of the invention for effecting slow (soft) switchings from one logic state to another, consists essentially in the use of an inverter driven by the logic value present on the respective signal line at the decoder output for driving the respective logic gate or, in the example shown, the control gate of one of the two complementary transistors of the respective passgate obviously duplicating the same driving structure for the other transistor of the pair forming the passgate.

In the embodiment depicted in Fig. 3, both the inverters, I1 and I2, being the latter driven by an inverter capable to invert the logic signal present at the respective decoder output, have their respective current terminals switcheable by a passgate between the respective common supply potential node and a node upon which a voltage ramp (negative ($\phi$) or positive ($\phi$1)) toward said respective common potential develops, as depicted or indicated in the relative diagram shown in the figure.

The passgates that switch the current terminals of the n pairs of inverters I1 and I2 are controlled by the logic signal that preexisted on the relative signal line before the intervened switching and by its inverse signal, which are available at the n output pairs of the n-bit latch that stores the preexistent configuration or code.

The different situations that can occur during operation for the i_th output of the n-bit decoder are described as follows.

**Case a):** high-to-low switching of the i_th ouput of the decoder

Initial condition at instant $t_0$
i_th output of the n-bit decoder = i_th output of the n-bit latch = high
$\phi 1$ = Vdd
$\phi 2$ = Gnd
Mn12 = closed; M13 = open; Mp12 = open; Mp13 = closed
therefore the inverter $I_1$ is supplied between $\phi 1$ = Vdd and Gnd
$I_1$ output = low
Mn22 = open; Mn23 = closed; Mp22 = closed; Mp23 = open
therefore the inverter I2 is supplied between Vdd and $\phi 2$ = Gnd
$I_2$ output = high
Fast switching high-to-low of the output of the decoder at instant $t_1$
i_th output of the n-bit decoder = low
i_th output of the latch n-bit = high
Mn12 = closed; Mn13 = open; Mp12 = open; Mp13 = closed as a to, being driven by the latch;
$\phi 1$ = Gnd, therefore $I_1$ output remains low.
Mn22 = open; Mn23 = closed; Mp22 = closed; Mp23 =

open as a $t_0$ being driven by the latch;
$\phi 2$ = Vdd, therefore $I_2$ output remains high.

Interval $t_1$ - $t_2$
i_th output of the n-bit decoder = low
i_th output of the n-bit latch = high
$\phi 1$ is linearty driven to Vdd, which is reached at the instant $t_2$;
the inverter $I_1$ presents the p_mos switched-on and the n_mos switched-off, so the p_mos drain current is negligible and its Vds is null. Therefore the output $I_1$ follows the course of $\phi 1$.
$\phi 2$ is linearly driven to Gnd, which is reached at the instant $t_2$;
the inverter $I_2$ presents the n_mos switched-on and the p_mos switched-off, so the n_mos drain current is negligible and its Vds is null. Therefore the output $I_2$ follows the course of $\phi 2$.

Instant $t_2$
the n-bit latch is up-dated;
i_th output of the n-bit decoder = low
i_th output of the n-bit latch = low
$\phi 1$ = Vdd
$\phi 2$ = Gnd
Mn12 = open; Mn13 = closed; Mp12 = closed; M13 = open
therefore the inverter $I_3$ is supplied between Vdd and $\phi 2$ = Gnd
$I_1$output = high
Mn22 = closed; Mn23 = open; Mp22 = open; Mp23 = closed
therefore the inverter I2 is supplied between $\phi 1$ = Vdd and Gnd
$I_2$ output = low

**Case b):** slow-to-high switching of the j_th ouput of the decoder

Initial condition at instant $t_0$
j_th output of the n-bit decoder = j_th output of the n-bit latch = low
$\phi 1$ = Vdd
$\phi 2$ = Gnd
Mn12 = open; M13 = closed; Mp12 = closed; Mp13 = open
therefore the inverter $I_1$ is supplied between Vdd and $\phi 2$ = Gnd
$I_1$ output = high
Mn22 = closed; Mn23 = open; Mp22 = open; Mp23 = closed
therefore the inverter $I_2$ is supplied between $\phi 1$ = Vdd and Gnd
$I_2$ output = low
Fast switching slow-to-high of the output of the decoder at instant $t_1$
j_th output of the n-bit decoder = high
j_th output of the latch n-bit = low
Mn12 = open; Mn13 = closed; Mp12 = closed; Mp13 = open as a $t_0$, being driven by the latch;

$\phi2$ = Vdd from which $I_1$ output remains high.

Mn22 = closed; Mn23 = open; Mp22 = open; Mp23 = closed as a $t_0$ being driven by the latch;

$\phi1$ = Gnd from which $I_2$ output remains low.

Interval $t_1$ - $t_2$

j_th output of the n-bit decoder = high

j_th output of the n-bit latch = low

$\phi2$ is linearly driven to Gnd, which is reached at the instant $t_2$;

the inverter $I_1$ presents the n_mos switched-on and the p_mos switched-off, so the n_mos drain current is negligible and its Vds is null. Therefore the output $I_1$ follows the course of $\phi2$.

$\phi1$ is linearly driven to Vdd, which reaches as a value at the instant $t_2$;

the inverter $I_2$ presents the p_mos switched-on and the n_mos switched-off, so the p_mos drain current is negligible and its Vds is null. Therefore the output $I_2$ follows the course of $\phi1$.

Instant $t_2$

the n-bit latch is up-dated;

j_th output of the n-bit decoder = high

j_th output of the n-bit latch = high

$\phi1$ = Vdd

$\phi2$ = Gnd

Mn12 = closed; Mn13 = open; Mp12 = open; M13 = closed

therefore the inverter $I_1$ is supplied between $\phi1$ = Vdd and Gnd.

$I_1$ output = low

Mn22 = open; Mn23 = closed; Mp22 = closed; Mp23 = open

therefore the inverter $I_2$ is supplied between Vdd and $\phi2$ = Gnd.

$I_2$ output = high.

**Case c)**: no switching of the k_th ouput of the decoder = high

Initial condition at instant $t_0$

k_th output of the n-bit decoder = k_th output of the n-bit latch = high

$\phi1$ = Vdd

$\phi2$ = Gnd

Mn12 = closed; M13 = open; Mp12 = open; Map13 = closed

therefore the inverter $I_1$ is supplied between $\phi1$ = Vdd and Gnd

$I_1$ output = low

Mn22 = open; Mn23 = closed; Mp22 = closed; Mp23 = open

therefore the inverter I2 is supplied between Vdd and $\phi2$ = Gnd

$I_2$ output = high

Instant $t_1$

k_th output of the n-bit decoder = k_th output of the n-bit latch = high

$\phi1$ = Gnd

$\phi2$ = Vdd

Mn12 = closed; Mn13 = open; Mp12 = open; Mp13 = closed as a to, being driven by the latch;

the $I_1$ inverter works between $\phi1$ and Gnd, but as its respective p_mos is switched-off the output does not suffer the transition on $\phi1$, which is maintained low by the n_mos switched-on (its drain current is negligible and its Vds is null);

therefore the output $I_1$ = low

Mn22 = open; Mn23 = closed; Mp22 = closed; Mp23 = open as a to being driven by the latch;

the inverter $I_2$ works between Vdd and $\phi2$, but as its respective n_mos is switched-off the output does not suffer the transition on $\phi2$, which is maintained high by the p_mos switched-on (its drain current is negligible and its Vds is null);

therefore the output $I_2$ = high

Interval $t_1$ - $t_2$

k_th output of the n-bit decoder = k_th output of the n-bit latch = high

$\phi1$ is linearly driven to Vdd, which is reached at the instant $t_2$;

the inverter $I_1$ works between $\phi1$ and Gnd, but as its respective p_mos is switched-off the output does not suffer the transition on $\phi1$, which is maintained low by the n_mos switched-on (its drain current is negligible and its Vds is null).

$\phi2$ is linearly driven to Gnd, which reaches as a value at the instant $t_2$;

the inverter $I_2$ works between Gnd and $\phi2$, but as its respective n_mos is switched-off the output does not suffer the transition on $\phi2$, which is maintained high by the p_mos switched_on (its drain current is negligible and its Vds is null);

Instant $t_2$

the n-bit latch is up-dated;

k_th output of the n-bit decoder = k_th output of the n-bit latch = high

$\phi1$ = Vdd

$\phi2$ = Gnd

Mn12 = closed; Mn13 = open; Mp12 = open; M13 = closed as a $t_0$ being driven by the latch;

therefore the output $I_1$ remains low.

Mn22 = open; Mn23 = closed; Mp22 = closed; Mp23 = open as a $t_0$ being driven by the latch;

therefore the $I_2$ output remains high.

**Case d)**: no switching of the p_th ouput of the decoder = low

Initial condition at instant $t_0$

p_th output of the n-bit decoder = p_th output of the n-bit latch = low

$\phi1$ = Vdd

$\phi2$ = Gnd

Mn12 = open; M13 = closed; Mp12 = closed; Mp13 = open

therefore the inverter $I_1$ is supplied between Vdd and $\phi2$ = Gnd.

$I_1$ output = high

Mn22 = closed; Mn23 = open; Mp22 = open; Mp23 = closed

therefore the inverter $I_2$ is supplied between $\phi1$ = Vdd and Gnd.

$I_2$ output = low

Instant $t_1$

p_th output of the n-bit decoder = p_th output of the n-bit latch = low

$\phi1$ = Gnd

$\phi2$ = Vdd

Mn12 = open; Mn13 = closed; Mp12 = closed; Mp13 = open as a $t_0$, being driven by the latch;

the $I_1$ inverter works between Vdd and $\phi2$, but as its respective n_mos is switched-off the output does not suffer the transition on $\phi2$, which is maintained high by the p_mos switched-on (its drain current is negligible and its Vds is null);

therefore the output $I_1$ = high

Mn22 = closed; Mn23 = open; Mp22 = open; Mp23 = closed as a $t_0$ being driven by the latch;

the inverter $I_2$ works between $\phi1$ and Gnd, but as its respective p_mos is switched-off the output does not suffer the transition on $\phi1$, which is maintained low by the n_mos switched-on (its drain current is negligible and its Vds is null);

therefore the output $I_2$ remains low.

Interval $t_1$ - $t_2$

p_th output of the n-bit decoder = p_th output of the n-bit latch = low

$\phi1$ is linearly driven to Gnd, which is reached at the instant $t_2$;

the inverter $I_1$ works between Vdd and $\phi2$, but as its respective n_mos is switched-off the output does not suffer the transition on $\phi2$, which is maintained high by the p_mos switched-on (its drain current is negligible and its Vds is null).

$\phi1$ is linearly driven to Vdd, which is reached at the instant $t_2$;

the inverter $I_2$ works between $\phi1$ and Gnd, but as its respective p_mos is switched-off the output does not suffer the transition on $\phi1$, which is maintained low by the n_mos switched-on (its drain current is negligible and its Vds is null);

therefore the output $I_2$ remains low.

Instant $t_2$

the n-bit latch is up-dated;

p_th output of the n-bit decoder = p_th output of the n-bit latch = low

$\phi1$ = Vdd

$\phi2$ = Gnd

Mn12 = open; Mn13 = closed; Mp12 = closed; M13 = open as a $t_0$ being driven by the latch;

therefore the output $I_1$ remains high.

Mn22 = closed; Mn23 = open; Mp22 = open; Mp23 = closed as a $t_0$ being driven by the latch;

therefore the $I_2$ output remains low.

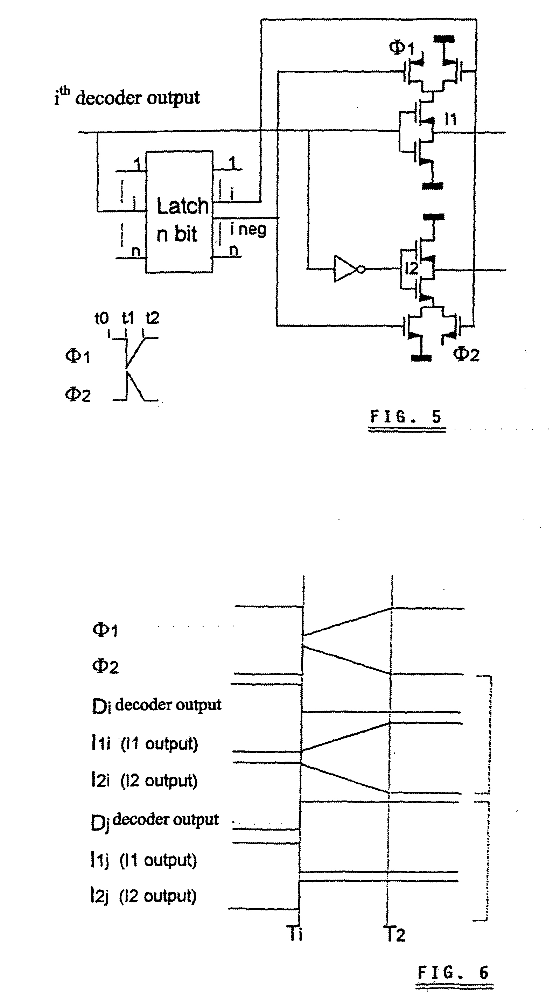

Diagrams of the signals for the cases a) and b) described above are shown in Fig. 4.

With reference to the diagram of Fig. 3, the entire driving circuit according to the present invention that is interposed in cascade to the decoder for "soft-switching" the passgates, in a quite comparable way to that of the known arrangement of Fig. 2, requires a number of components that is given by the following expression:

$$n_{latch}+n(n_{new}+n_{inverter})=22*n+4$$

where:

n = number of outputs of the decoder

$n_{latch}$ = number of components of the n-bitlatch=n*8+4

$n_{new}$ = number of components of the driving circuit module that drives each mos of the passgate = 6

$n_{inverter}$ = number of components of the inverter = 2.

If we consider the number of decoder outputs equal to eight (n=8), as is commonly the case for a large number of applications, we observe a 27% decrease in the total number of components if compared to a known architecture like that described in Fig. 2.

The real effects upon the die-size are indeed more consistent than a simple decrease in the total number of components would let suppose, because all the components required by the driving architecture of the invention may be devices of a minimum size. This is not entirely possible according to the known approaches, because in order to ensure a sufficiently fast reconfiguration of the driving circuit, the switches of the scheme shown in Fig. 2 need to be implemented with integrated devices of adequate size, substantially larger than the minimum size. Moreover, the peculiar compactness of the layout of the driving circuit of the invention provides for a more efficient connectivity and for a reduced utilization of silicon area for "wiring" the components as compared to the known solution of Fig. 2.

Naturally, the invention can be also practiced in different ways depending on the specific requirements of the whole system. In particular, if the system requires a "soft-switching" only during one phase, either of opening or closing of the passgate, the number of components may be reduced accordingly.

This reduced form of embodiment is schematically shown in Fig. 5. In this case only the current terminal toward supply voltage node of the inverter I1 and only the current terminal toward the ground of the inverter I2 are switcheable by a respective passgate between the relative supply node and a node upon which a positive or negative voltage ramp, respectively, is produced by a suitable ramp generator.

Diagrams of the signals of the circuit of Fig. 5 are shown in Fig. 6.

The invention is particularly, even if not exclusively, useful in analog audio processors in which the adjustment of certain functional parameters is performed by means of digital commands.

## Claims

1. A circuit for driving in a "soft-switching" fashion a logic gate subject to undergo a transition from a logic state to another, comprising means for coupling a control node of said logic gate to a generator of a negative or positive signal ramp ($\Phi1$; $\Phi2$) depending on the direction of said transition,
   at least one inverter (I1, I2), driven by the logic signal insistent on a respective input signal line (1; i), driving said control node of the logic gate,
   a passgate (Mp12, Mp13; Mn12, Mn13) coupled in series to at least one of the two current terminals of said inverter for switching the inverter terminal from the respective common supply potential node to a node on which said ramp signal ($\Phi1$; $\Phi2$) toward said common supply potential is produced,
   **characterized in that** said means comprise
   a latch (LATCH) for storing the logic state preexistent a current switching command;
   said passgate being controlled by the preexistent stored logic signal stored in said latch (1; i) and by its inverse (1NEG; ineg).

2. The circuit as defined in claim 1, wherein a passgate (Mp12, Mp13; Mn12, Mn13) controlled by said preexistent logic signal (1) and its inverse (1NEG) is coupled in series to each of the current terminals of said inverter (I1) that are switcheable between their respective common supply potential node and a node on which said ramp signal toward said supply potential is produced.

3. The circuit as defined in claim 1, **characterized in that** said logic gate is a passgate, the n channel transistor of which (N_MOS) is controlled by a first inverter (I1) driven by the logic signal (1; i) present on the respective input signal line and the p channel transistor of which (P_MOS) is controlled by a second inverter (I2) driven by the inverse of said logic signal (1; i);
   each inverter having a passgate (Mp12, Mp13; Mn12, Mn13) coupled in series with at least a current terminal of the inverter for switching it from its respective common supply potential node to a node on which said ramp signal ($\Phi1$; $\Phi2$) toward said respective common supply potential is produced;
   said passgates (Mp12, Mp13; Mn12, Mn13) coupled in series to the current terminal of the inverters being driven by the preexistent logic signal stored in said latch (1; i) and by its inverse (1NEG;

ineg).

4. A method of "soft-switching" a logic gate subject to undergo a transition from one logic state to another, comprising coupling the control node of said logic gate to a generator of a positive or negative voltage ramp signal ($\Phi1$; $\Phi2$) depending on the direction of said transition,
   driving said control node of the logic gate through an inverter (I1, I2),
   switching at least a current terminal of the inverter from the respective common supply potential node to a node on which said voltage ramp signal ($\Phi1$; $\Phi2$) toward the respective common supply potential is produced by using a passgate (Mp12, Mp13; Mn12, Mn13),
   **characterized in that** comprises
   storing in a latch (LATCH) of the logic state preexisting a current switching command,
   controlling said passgate by said stored preexistent logic signal (1; i) and its inverse (1NEG; ineg).

5. The method as defined in claim 4, **characterized in that** both the current terminals of said inverter are switched by means of a respective passgate (Mp12, Mp13; Mn12, Mn13) from the respective common supply potential node to a node on which said ramp signal toward said supply potential is produced.

6. The method as defined in claim 4, wherein said logic gate subject to a transition from a logic state into another is a passgate and which comprises
   driving the n channel transistor (N_MOS) of the passgate by means of a first inverter (I1) driven by an input logic signal;
   driving the p channel transistor (P_MOS) of said passgate by means of a second inverter (I2) driven by the inverse of said input logic signal (1; i);
   switching at least one current terminal of each inverter from the respective common supply potential node to a node on which said voltage ramp signal ($\Phi1$; $\Phi2$) toward the respective common supply potential is produced by means of a respective passgates (Mp12, Mp13; Mn12, Mn13) controlled by the stored preexisting logic signal (1; i) and its inverse (1NEG; ineg).

7. Analog audio processor provided with means for adjusting and/or controlling a certain functioning parameter including a digitally commanded, in a mutually exclusive mode, of logic gates of n multiplated signal lines corresponding to as many outputs of a decoder of multibit digital command, **characterized in that** it comprises
   a circuit for implementing a "soft-switching" of the logic gates of said array as defined in claim 1.

**Patentansprüche**

1. Schaltung zum Treiben in einer "sanften Schaltweise" eines logischen Gatters, das einem Übergang von einem logischen Zustand zu einem anderen unterworfen ist, die aufweist: Einrichtungen zur Kopplung eines Steuerknotens des logischen Gatters mit einem Generator einer negativen oder positiven Signalrampe (Φ1;Φ2) abhängig von der Richtung des Übergangs, mindestens einen Inverter (I1,I2), der durch das Logiksignal getrieben wird, das auf einer jeweiligen Eingangssignalleitung (1;i) vorhanden ist, die den Steuerknoten des logischen Gatters treibt, ein Passgate (Mp12, Mp13; Mn12, Mn13), das mit mindestens einem der beiden Stromanschlüsse des Inverters in Reihe geschaltet ist, um den Inverteranschluß vom jeweiligen gemeinsamen Versorgungspotentialknoten auf einen Knoten umzuschalten, an dem das Rampensignal (Φ1;Φ2) zu dem gemeinsamen Versorgungspotential erzeugt wird, **dadurch gekennzeichnet, daß** die Einrichtungen aufweisen:

   eine Verriegelungsschaltung (LATCH) zum Speichern des logischen Zustands, der vor einem gegenwärtigen Schaltbefehl vorhanden war;

   wobei das Passgate durch das zuvor vorhandene gespeicherte Logiksignal, das in der Verriegelungsschaltung (1;i) gespeichert ist, und durch sein Inverses (1NEG;ineg) gesteuert wird.

2. Schaltung nach Anspruch 1, wobei ein Passgate (Mp12, Mp13; Mn12, Mn13), das durch das zuvor vorhandene Logiksignal (1) und sein Inverses (1NEG) gesteuert wird, in Reihe mit jedem der Stromanschlüsse des Inverters (I1) geschaltet ist, die zwischen ihren jeweiligen gemeinsamen Versorgungspotentialknoten und einem Knoten umschaltbar sind, an dem das Rampensignal zum Versorgungspotential hin erzeugt wird.

3. Schaltung nach Anspruch 1, **dadurch gekennzeichnet, daß** das logische Gatter ein Passgate ist, dessen N-Kanal-Transistor (N_MOS) durch einen ersten Inverter (I1) gesteuert wird, der durch das Logiksignal (1;i) getrieben wird, das auf der jeweiligen Eingangssignalleitung vorhanden ist, und dessen P-Kanal-Transistor (P_MOS) durch einen zweiten Inverter (I2) gesteuert wird, der durch das Inverse des Logiksignals (1;i) gesteuert wird; wobei jeder Inverter ein Passgate (Mp12, Mp13; Mn12, Mn13) aufweist, das in Reihe mit mindestens einem Stromanschluß des Inverters geschaltet ist, um ihn von seinem jeweiligen gemeinsamen Versorgungspotentialknoten auf einen Knoten umzuschalten, an dem das Rampensignal (Φ1; Φ2) zum jeweiligen gemeinsamen Versorgungspotential hin erzeugt wird; wobei die Passgates (Mp12, Mp13; Mn12, Mn13), die in Reihe mit dem Stromanschluß der Inverter geschaltet sind, durch das zuvor vorhandene Logiksignal, das in der Verriegelungsschaltung (1;i) gespeichert ist, und durch sein Inverses (1NEG;ineg) gesteuert werden.

4. Verfahren zum "sanften Schalten" eines logischen Gatters, das einem Übergang von einem logischen Zustand zu einem anderen unterworfen wird, das aufweist: Koppeln des Steuerknotens des logischen Gatters mit einem Generator eines positiven oder negativen Spannungsrampensignals (Φ1;Φ2) abhängig von der Richtung des Übergangs, Treiben des Steuerknotens des logischen Gatters durch einen Inverter (I1, I2), Schalten mindestens eines Stromanschlusses des Inverters vom jeweiligen gemeinsamen Versorgungspotentialknoten zu einem Knoten, an dem das Spannungsrampensignal (Φ1;Φ2) zu dem jeweiligen gemeinsamen Versorgungspotential durch Verwendung eines Passgates (Mp12, Mp13; Mn12, Mn13) erzeugt wird, **dadurch gekennzeichnet, daß** es aufweist Speichern in einer Verriegelungsschaltung (LATCH) des logischen Zustands, der vor einem gegenwärtigen Schaltbefehl vorhanden war, Steuerung des Passgates durch das zuvor vorhandene Logiksignal (1;i) und seinem Inversen (1NEG; ineg).

5. Verfahren nach Anspruch 4, **dadurch gekennzeichnet, daß** beide Stromanschlüsse des Inverters mittels eines jeweiligen Passgates (Mp12, Mp13; Mn12, Mn13) von einem jeweiligen gemeinsamen Versorgungspotentialknoten auf einen Knoten umgeschaltet werden, an dem das Rampensignal zum Versorgungspotential hin erzeugt wird.

6. Verfahren nach Anspruch 4, wobei das logische Gatter, das einem Übergang von einem logischen Zustand zu einem anderen unterworfen ist, ein Passgate ist, das aufweist:

   Treiben des N-Kanal-Transistors (N_MOS) des Passgates mittels eines ersten Inverters (I1), der durch ein Eingangslogiksignal getrieben wird; Treiben des P-Kanal-Transistors (P_MOS) des Passgates mittels eines zweiten Inverters (I2), der durch das Inverse des Eingangslogiksignals (1;i) getrieben wird; Schalten mindestens eines Stromanschlusses jedes Inverters vom jeweiligen gemeinsamen Versorgungspotentialknoten auf einen Knoten, an dem das Spannungsrampensignal (Φ1; Φ2) zum jeweiligen gemeinsamen Versorgungspotential hin mittels eines jeweiligen Passgates (Mp12, Mp13; Mn12, Mn13) erzeugt wird, das durch das gespeicherte zuvor vorhandene Logiksignal (1;i) und seinem Inversen (1NEG;ineg) gesteuert wird.

**7.** Analoger Audioprozessor, der mit Einrichtungen zur Einstellung und/oder Steuerung eines bestimmten Funktionsparameters versehen ist, einschließlich eines digital befohlenen, in einer gegenseitig ausschließlichen Weise, von logischen Gattern von n gemultiplexten Signalleitungen, die ebenso vielen Ausgängen eines Decoders für einen digitalen Multibitbefehl entsprechen, **dadurch gekennzeichnet, daß** er eine Schaltung zur Implementierung eines "sanften Schaltens" der logischen Gatter der Anordnung nach Anspruch 1 aufweist.

## Revendications

**1.** Circuit pour piloter en "commutation progressive" une porte logique soumise à une transmission d'un état logique à un autre, comprenant un moyen de couplage d'un noeud de commande de la porte logique à un générateur de rampe de signal négatif ou positif (Φ1 ; Φ2) selon la direction de la transition ;

au moins un inverseur (I1, I2) piloté par le signal logique apparaissant sur une ligne de signal d'entrée respective (1 ; i) pilotant le noeud de commande de la porte logique ;

une porte de transfert (Mp12, Mp13 ; Mn12, Mn13) couplée en série avec au moins l'une des deux bornes de courant de l'inverseur pour commuter la borne d'inverseur du noeud de potentiel d'alimentation respectif à un noeud sur lequel le signal en rampe (Φ1 ; Φ2) vers le potentiel d'alimentation commun est produit ;

**caractérisé en ce que** ledit moyen comprend :

une bascule (LATCH) pour mémoriser l'état logique préexistant à une commande de commutation courante ;

la porte de transfert étant commandée par le signal logique préexistant mémorisé par la bascule (1 ; i) et par son inverse (1NEG ; ineg).

**2.** Circuit selon la revendication 1, dans lequel la porte de transfert (Mp12, Mp13 ; Mn12, Mn13) commandée par le signal logique préexistant (1) et son inverse (1NEG) est couplée en série avec chacune des bornes de courant de l'inverseur (I1) qui sont commutables entre leur noeud de potentiel d'alimentation commun respectif et un noeud sur lequel le signal en rampe vers le potentiel d'alimentation est produit.

**3.** Circuit selon la revendication 1, **caractérisé en ce que** la porte logique est une porte de transfert, dont le transistor à canal N (N_MOS) est commandé par un premier inverseur (I1) piloté par un signal logique (1 ; i) présent sur la ligne de signal d'entrée respective et dont le transistor à canal P (P_MOS) est commandé par un second inverseur (I2) piloté par l'inverse du signal logique (1 ; i) ;

chaque inverseur comprenant une porte de transfert (Mp12, Mp13 ; Mn12, Mn13) couplée en série avec au moins une borne de courant de l'inverseur pour le commuter de son noeud de potentiel d'alimentation commun respectif à un noeud sur lequel le signal en rampe (Φ1 ; Φ2) vers le potentiel d'alimentation commun respectif est produit ;

lesdites portes de transfert (Mp12, Mp13 ; Mn12, Mn13) couplées en série avec la borne de courant des inverseurs étant pilotées par le signal logique préexistant mémorisé dans la bascule (1 ; i) et par son inverse (1NEG ; ineg).

**4.** Procédé de "commutation progressive" d'une porte logique soumise à une transition d'un premier état logique à un autre, comprenant le couplage du noeud commun de la porte logique à un générateur d'un signal en rampe de tension positif ou négatif (Φ1 ; Φ2) selon la direction de la transition,

, piloter le noeud de commande de la porte logique par l'intermédiaire d'un inverseur (I1, I2) ;

commuter au moins une borne de courant de l'inverseur depuis le noeud de potentiel d'alimentation commun à un noeud sur lequel le signal en rampe de tension (Φ1 ; Φ2) vers le potentiel d'alimentation commun respectif est produit en utilisant une porte de transfert (Mp12, Mp13 ; Mn12, Mn13) ;

**caractérisé en ce qu'**il comprend :

mémoriser dans une bascule (LATCH) l'état logique préexistant à une commande de commutation courante ;

commander la porte de transfert par le signal logique préexistant (1 ; i) et son inverse (1NEG ; ineg).

**5.** Procédé selon la revendication 4, **caractérisé en ce que** les bornes de courant de l'inverseur sont commutées au moyen d'une porte de transfert (Mp12, Mp13 ; Mn12, Mn13) respective depuis le noeud de potentiel d'alimentation commun respectif jusqu'à un noeud sur lequel le signal en rampe vers le potentiel d'alimentation est produit.

**6.** Procédé selon la revendication 4, dans lequel la porte logique soumise à une transition d'un état logique à un autre est une porte de transfert, et comprenant :

piloter le transistor à canal N (N_MOS) de la porte de transfert par un premier inverseur (I1) piloté par un signal logique d'entrée ;

piloter le transistor à canal P (P_MOS) de la porte de transfert par un second inverseur (I2) piloté par l'inverse du signal logique d'entrée (1 ; i) ;

commuter au moins une borne de courant de chaque inverseur depuis le noeud de potentiel commun d'alimentation jusqu'à un noeud sur lequel le signal en rampe de tension (Φ1 ; Φ2) vers le potentiel d'alimentation commun respectif est produit au moyen de portes de transfert (Mp12, Mp13 ; Mn12, Mn13) respectives commandées par le signal logique préexistant mémorisé (1 ; i) et son inverse (1NEG ; ineg).

7. Processeur audio analogique muni de moyens pour régler et/ou commander un certain paramètre de fonctionnement incluant des portes logiques commandées numériquement, dans un mode mutuellement exclusif, de n lignes de signal correspondant à autant de sorties d'un décodeur de commande numérique multibits, **caractérisé en ce qu'**il comprend :

un circuit pour réaliser une "commutation progressive" des portes logiques du réseau défini en revendication 1.

FIG. 1

FIG. 2

FIG. 3

FIG. 4

FIG. 5

FIG. 6